# EUROPEAN PATENT APPLICATION

(11) **EP 2 866 265 A1**
(43) Date of publication of application: **29.04.2015**
(21) Application number: 13810423.7
(22) Date of filing: 19.04.2013
(51) Int. Cl.: H01L 29/78, H01L 21/302, H01L 21/336, H01L 29/12

(54) **METHOD OF MANUFACTURING SILICON CARBIDE SEMICONDUCTOR DEVICE AND SILICON CARBIDE SEMICONDUCTOR DEVICE**

(30) Priority: 26.06.2012 JP 2012142622
(71) Applicant: Sumitomo Electric Industries, Ltd., Osaka-shi, Osaka 541-0041 (JP)
(72) Inventor: SAITOH, Yu, Osaka-shi Osaka 554-0024 (JP); MASUDA, Takeyoshi, Osaka-shi Osaka 554-0024 (JP); TANAKA, Sou, Osaka-shi Osaka 554-0024 (JP); HIRATSUKA, Kenji, Osaka-shi Osaka 554-0024 (JP); SHIMAZU, Mitsuru, Osaka-shi Osaka 554-0024 (JP); KANBARA, Kenji, Osaka-shi Osaka 554-0024 (JP)
(74) Representative: Grünecker Patent- und Rechtsanwälte PartG mbB
(86) International application number: PCT/JP2013/061600
(87) International publication number: WO 2014/002589

(57) **Abstract**

A first layer (121) of a first conductivity type made of silicon carbide is formed. A second layer (122) of a second conductivity type different from the first conductivity type positioned on the first layer (121), and a third layer (123) of the first conductivity type positioned on the second layer (122) are formed. The step of forming second and third layers (122, 123) includes the steps of performing impurity ion implantation, and performing heat treatment for activating impurities implanted by the impurity ion implantation. After the step of performing heat treatment, a trench (TR) having a side wall penetrating the third layer (123) and the second layer (122) and having a bottom reaching the first layer (121) is formed. A gate insulating film (201) to cover the side wall of the trench (TR) is formed. As a result, a silicon carbide semiconductor device (500) having a low ON resistance is provided.

## Description

### TECHNICAL. FIELD

The present invention relates to a method for manufacturing a silicon carbide semiconductor device and a silicon carbide semiconductor device.

### BACKGROUND ART

Japanese Patent Laying-Open No. 2012-38770 (Patent Document 1) discloses a method for manufacturing a trench type MOSFET (Metal Oxide Semiconductor Field Effect Transistor) which is a silicon carbide semiconductor device. According to an example of this manufacturing method, first, an epitaxial layer to serve as a breakdown voltage holding layer is formed on a substrate Then, ion implantation is performed into the epitaxial layer to form a p type body layer and an n type source contact layer on the breakdown voltage holding layer. A groove (trench) is then formed by thermal etching Next, an electric field relaxation layer is formed at the bottom of the trench by ion implantation. Then, activation annealing (heat treatment) is performed. Subsequently, a gate insulating film and a gate electrode are formed.

### CITATION LIST

### PATENT DOCUMENT

PTD 1: Japanese Patent Laying-Open No. 2012-38770

### SUMMARY OF INVENTION

### TECHNICAL PROBLEM

The silicon carbide semiconductor devices having a trench type insulating gate obtainable at the present time, including the MOSFET in the above example, have a channel resistance much higher than a theoretically expected value. Thus, the ON resistance has not been able to be sufficiently reduced.

The present invention was made to solve the problems as described above, and an object of the present invention is to provide a silicon carbide semiconductor device having a low ON resistance.

### SOLUTION TO PROBLEM

A method for manufacturing a silicon carbide semiconductor device according to the present invention includes the following steps. A first layer of a first conductivity type made of silicon carbide is formed. A second layer of a second conductivity type different from the first conductivity type positioned on the first layer, and a third layer of the first conductivity type positioned on the second layer are formed. The step of forming second and third layers includes the steps of performing impurity ion implantation, and performing heat treatment for activating impurities implanted by the impurity ion implantation. After the step of performing heat treatment, a trench having a side wall penetrating the third layer and the second layer and having a bottom reaching the first layer is formed. A gate insulating film is formed to cover the side wall of the trench. A gate electrode is formed on the gate insulating film.

According to this manufacturing method, the trench forming a channel surface is formed after the activation heat treatment is performed. Therefore, once formed, the channel surface is not disturbed by the activation heat treatment. Consequently, the channel resistance is suppressed, thereby reducing the ON resistance.

Preferably, the step of performing impurity ion implantation includes the following steps. An impurity for providing the second layer with the second conductivity type is implanted. An impurity for providing the third layer with the first conductivity type is implanted.

Consequently, the second and third layers can be formed by the activation heat treatment above.

Preferably, the step of forming a trench includes the following steps A mask layer having an opening to partially expose the third layer is formed on the third layer. Preliminary etching having a physical action is performed using the mask layer. Thermal etching is performed after the step of performing preliminary etching.

Consequently, the channel resistance is further suppressed, thereby further reducing the ON resistance

Preferably, a sacrificial oxide film is formed by oxidizing the bottom of the trench, and then the sacrificial oxide film is removed.

Consequently, a corner portion at the bottom of the trench can be further smoothed. Thus, electric field concentration in this corner portion can be suppressed to increase the breakdown voltage.

Preferably, in the method for manufacturing a silicon carbide semiconductor device, the gate insulating film and the gate electrode are formed without impurity ion implantation into the bottom of the trench.

Consequently, the silicon carbide semiconductor device is manufactured without impurity implantation into the bottom of the trench Accordingly, it is not intended to perform activation annealing after forming the trench. Therefore, once formed on the surface of the trench, the channel surface is not disturbed by the activation heat treatment. Consequently, the channel resistance is suppressed, thereby reducing the ON resistance.

A silicon carbide semiconductor device according to the present invention includes a silicon carbide substrate, a gate insulating film, and a gate electrode. The silicon carbide substrate includes first to third layers. The first layer is of a first conductivity type. The second layer is of a second conductivity type different from the first conductivity type on the first layer. The third layer is of the first conductivity type on the second layer. The silicon carbide substrate is provided with a trench. The trench has a side wall and a bottom. The side wall penetrates the third layer and the second layer. The bottom reaches the first layer. The second layer has a surface with a surface roughness of not more than 2 nm in RMS (Root Mean Square) on the side wall of the trench The gate insulating film covers the side wall of the trench. The gate electrode is on the gate insulating film

According to this silicon carbide semiconductor device, the side wall of the trench forms a channel surface having satisfactory flatness. Consequently, the channel resistance is suppressed, thereby reducing the ON resistance.

Preferably, the second layer is made of silicon carbide having a hexagonal crystal structure of polytype 4H, and the surface of the second layer includes a first plane having a plane orientation of {0-33-8}

Consequently, the channel surface includes a first plane having a plane orientation of {0-33-8}. Consequently, the channel resistance is suppressed, thereby reducing the ON resistance.

Preferably, the surface includes the first plane microscopically, and further includes a second plane having a plane orientation of {0-11-1} microscopically

Consequently, the channel resistance can be further suppressed, thereby further reducing the ON resistance.

Preferably, the first and second planes form a combined plane having a plane orientation of {0-11-2}.

Consequently, the channel resistance can be further suppressed, thereby further reducing the ON resistance.

Preferably, the surface macroscopically has an off angle of 62°±10° relative to the {000-1} plane.

Consequently, the channel resistance can be further suppressed, thereby further reducing the ON resistance.

### ADVANTAGEOUS EFFECTS OF INVENTION

As described above, according to the present invention, the ON resistance can be reduced by suppressing the channel resistance.

### BRIEF DESCRIPTION OF DRAWINGS

Fig. 1 is a partial cross-sectional view schematically showing the structure of a silicon carbide semiconductor device in one embodiment of the present invention.
Fig 2 is a partial perspective view schematically showing the structure of a silicon carbide substrate included in the silicon carbide semiconductor device of Fig. 1
Fig 3 is a flow chart schematically showing a method for manufacturing the silicon carbide semiconductor device of Fig. 1.
Fig. 4 is a flow chart showing greater details of Fig. 3.
Fig 5 is a partial cross-sectional view schematically showing a first step of the method for manufacturing the silicon carbide semiconductor device of Fig. 1.
Fig 6 is a partial cross-sectional view schematically showing a second step of the method for manufacturing the silicon carbide semiconductor device of Fig. 1.
Fig. 7 is a partial cross-sectional view schematically showing a third step of the method for manufacturing the silicon carbide semiconductor device of Fig. 1.
Fig. 8 is a partial cross-sectional view schematically showing a fourth step of the method for manufacturing the silicon carbide semiconductor device of Fig. 1.
Fig. 9 is a partial cross-sectional view schematically showing a fifth step of the method for manufacturing the silicon carbide semiconductor device of Fig. 1.
Fig. 10 is a partial cross-sectional view schematically showing a sixth step of the method for manufacturing the silicon carbide semiconductor device of Fig. 1.
Fig. 11 is a partial cross-sectional view schematically showing a seventh step of the method for manufacturing the silicon carbide semiconductor device of Fig 1.
Fig. 12 is a partial cross-sectional view schematically showing an eighth step of the method for manufacturing the silicon carbide semiconductor device of Fig. 1,
Fig. 13 is a partial cross-sectional view schematically showing a ninth step of the method for manufacturing the silicon carbide semiconductor device of Fig. 1.
Fig. 14 is a partial cross-sectional view schematically showing a tenth step of the method for manufacturing the silicon carbide semiconductor device of Fig. 1.
Fig. 15 is a partial cross-sectional view schematically showing an eleventh step of the method for manufacturing the silicon carbide semiconductor device of Fig. 1.
Fig. 16 is a partial cross-sectional view schematically showing a twelfth step of the method for manufacturing the silicon carbide semiconductor device of Fig. 1.
Fig. 17 is a partial cross-sectional view schematically showing a thirteenth step of the method for manufacturing the silicon carbide semiconductor device of Fig. 1.
Fig 18 is a partial cross-sectional view schematically showing an example of a fine structure of a channel surface of the silicon carbide semiconductor device of Fig. 1.
Fig. 19 shows a crystal structure of the (000-1) plane in a hexagonal crystal of polytype 4H.
Fig. 20 shows a crystal structure of the (11-20) plane along a line XX-XX in Fig. 19.
Fig. 21 shows a crystal structure in the (11-20) plane in the vicinity of a surface of a combined plane of Fig. 18.
Fig. 22 shows the combined plane of Fig. 18 when viewed from the (01 - 10) plane.
Fig 23 is a graph chart showing one exemplary relation between channel mobility and an angle between the channel surface and the (000-1) plane when viewed macroscopically, in each of a case where thermal etching is performed and a case where thermal etching is not performed.
Fig. 24 is a graph chart showing one exemplary relation between channel mobility and an angle between the channel direction and the <0-11-2> direction.
Fig. 25 shows a variation of Fig. 18.

### DESCRIPTION OF EMBODIMENTS

The embodiments of the present invention will be described hereinafter with reference to the drawings. It is noted that the same or corresponding parts are designated by the same reference numbers in the following drawings, and description thereof will not be repeated. Regarding crystallographic descriptions in the present specification, an individual orientation is represented by [], a group orientation is represented by <>, an individual plane is represented by (), and a group plane is represented by {}. In addition, although a negative crystallographic index is usually indicated by putting "-" (bar) above a numeral, it is indicated by putting a negative sign before the numeral in the present specification.

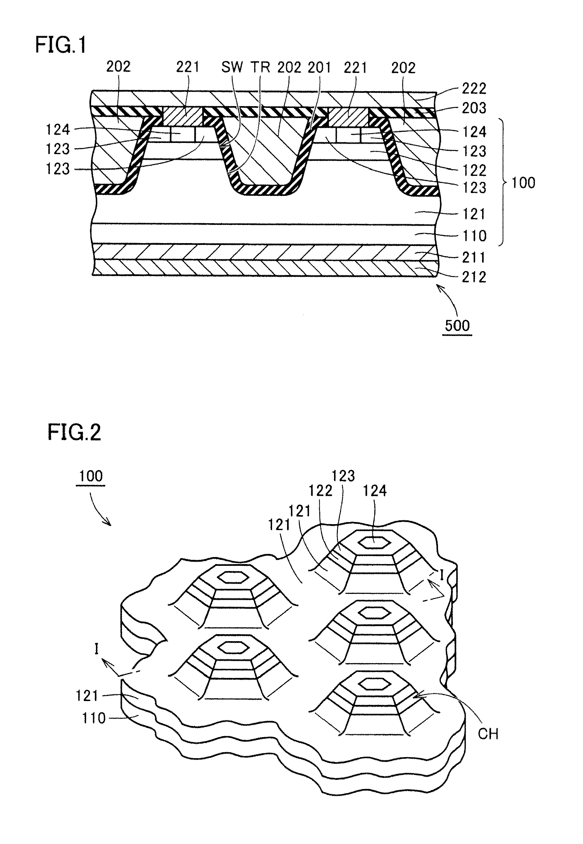

As shown in Fig 1, a vertical type MOSFET 500 (silicon carbide semiconductor device) in this embodiment includes an epitaxial substrate 100 (silicon carbide substrate), a gate oxide film 201 (gate insulating film), a gate electrode 202, an interlayer insulating film 203, a source electrode 221, a drain electrode 211, a source line 222, and a protection electrode 212.

Epitaxial substrate 100 is made of silicon carbide This silicon carbide preferably has a hexagonal crystal structure, and more preferably has a polytype 4H. Single-crystal substrate 110 has one main surface (upper surface in Fig. 1) having a plane orientation which preferably corresponds substantially to the (000-1) plane.

Epitaxial substrate 100 has a single-crystal substrate 110 and an epitaxial layer provided thereon. Single-crystal substrate 110 is of n type (first conductivity type). The epitaxial layer includes an n⁻ layer 121 (first layer), a p type body layer 122 (second layer), an n region 123 (third layer), and a contact region 124.

N⁻ layer 121 is of n type (first conductivity type). N⁻ layer 121 has a donor concentration lower than in single-crystal substrate 110. The donor concentration in n⁻ layer 121 is preferably not less than I × 10¹⁵/cm³ and not more than 5 × 10¹⁶/cm³, and is set to 8 × 10¹⁵/cm³, for example. P type body layer 122 is provided on n⁻ layer 121, and is of p type (second conductivity type). P type body layer 122 has an acceptor concentration of, for example, 1 × 10¹⁸/cm³. Contact region 124 is formed on a portion of p type body layer 122 so as to be connected to p type body layer 122.

Epitaxial substrate 100 is provided with a trench TR having a side wall and a bottom. The side wall of trench TR penetrates n region 123 and p type body layer 122, so that the bottom of trench TR reaches n⁻ layer 121. The side wall of trench TR has a surface SW as a channel surface on p type body layer 122. The surface has a roughness of not more than 2 nm in RMS. Preferably, surface SW has a predetermined crystal plane (also referred to as "special plane"). The special plane will be described later in detail.

That epitaxial substrate 100 has trench TR corresponds to the fact that, as shown in Fig 2, the epitaxial layer has been partially removed in the upper surface of single-crystal substrate 110. In this embodiment, a large number of mesa structures are formed on the upper surface of single-crystal substrate 110. Specifically, each mesa structure has an upper surface and a bottom surface each in a hexagonal shape, and has a side wall inclined relative to the upper surface of single-crystal substrate 110.

Gate oxide film 201 covers trench TR. Specifically, gate oxide film 201 is provided on surface SW and the bottom of trench TR. This gate oxide film 201 extends onto the upper surface of n region 123. Gate electrode 202 is provided on gate oxide film 201 to fill trench TR (that is, to fill the space between the mesa structures directly adjacent to each other). Gate electrode 202 faces surface SW of p type body layer 122, with gate oxide film 201 interposed therebetween. Gate electrode 202 has an upper surface substantially as high as the upper surface of a portion of gate oxide film 201 on the upper surface of n region 123. Interlayer insulating film 203 is provided to cover gate electrode 202 as well as the portion of gate oxide film 201 that extends onto the upper surface of n region 123.

Source electrode 221 is provided at the apex portion of each mesa structure. Source electrode 221 is in contact with each of contact region 124 and n region 123. Source line 222 is in contact with source electrode 221, and extends on the upper surface of interlayer insulating film 203. Drain electrode 211 is an ohmic electrode provided on the backside surface of single-crystal substrate 110 opposite to its main surface on which n⁻ layer 121 is provided. Protection electrode 212 is provided on drain electrode 211.

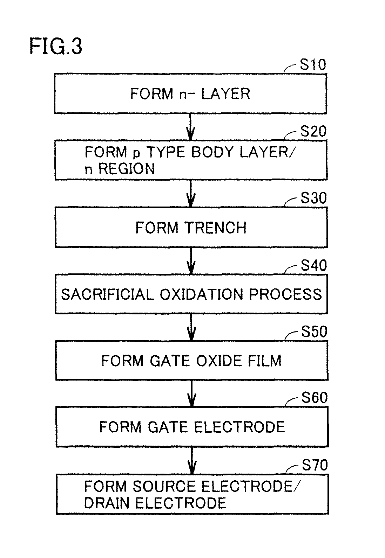

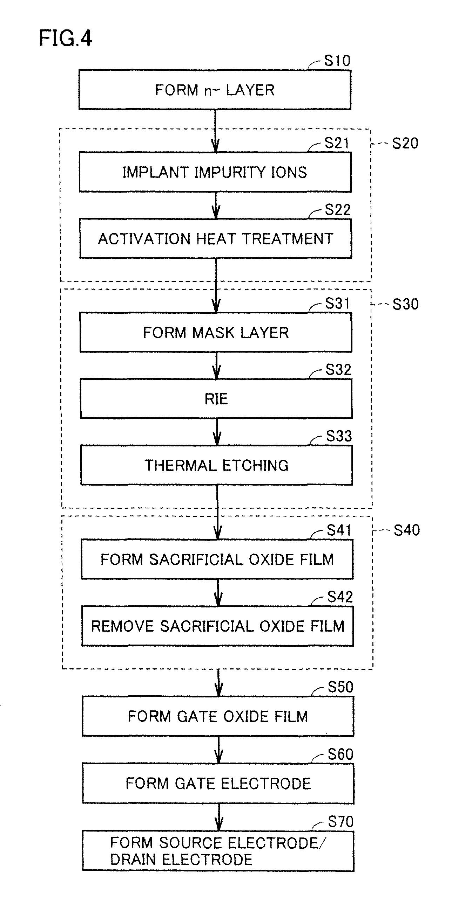

As shown in Fig. 3, a method for manufacturing MOSFET 500 mainly includes steps S10 to S70. Furthermore, as shown in Fig. 4, step S20 includes steps S21 and S22, step S30 includes steps S31 to S33, and step S40 includes steps S41 and S42. This manufacturing method will be described in detail.

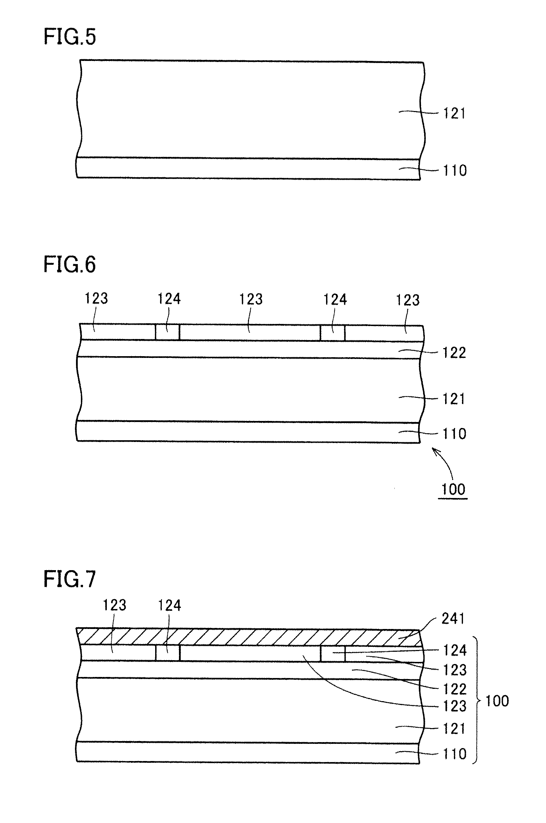

In step S10 (Figs. 3 and 4), as shown in Fig. 5, n⁻ layer 121 is formed by epitaxial growth on single-crystal substrate 110. This epitaxial growth can be implemented by CVD (Chemical Vapor Deposition) that utilizes a mixed gas of silane (SiH₄) and propane (C₃H₈) as a material gas and utilizes hydrogen gas (H₂) as a carrier gas, for example In so doing, it is preferable to introduce nitrogen (N) or phosphorus (P), for example, as an impurity of n type conductivity

In step S20 (Fig. 3), as shown in Fig. 6, p type body layer 122, n region 123 and contact region 124 are formed as follows.

First, in step S21 (Fig. 4), impurity ion implantation is performed into the upper surface of n⁻ layer 121, to form portions that will become p type body layer 122, n region 123 and contact region 124. In the ion implantation for forming p type body layer 122 and contact region 124, ions of an impurity for providing p type (i.e., acceptor) such as aluminum (Al) are implanted. In the ion implantation for forming n region 123, ions of an impurity for providing n type (i.e., donor) such as nitrogen (N) or phosphorus (P) are implanted. It is noted that epitaxial growth may be performed instead of the ion implantation

Then, in step S22 (Fig. 4), heat treatment is performed to activate the impurities implanted by the impurity ion implantation The heat treatment temperature is nor less than 1200°C, and preferably not less than 1600°C. The heat treatment temperature is preferably nor more than 1950°C. An optimal heat treatment temperature is, for example, approximately 1900°C. During the heat treatment, it is preferable to temporarily provide an annealing cap 241 on n region 123 and contact region 124 as shown in Fig. 7. The annealing cap is a carbon film, for example.

P type body layer 122, n region 123 and contact region 124 are thus formed.

Next, in step S30 (Fig. 3), trench TR is formed as follows.

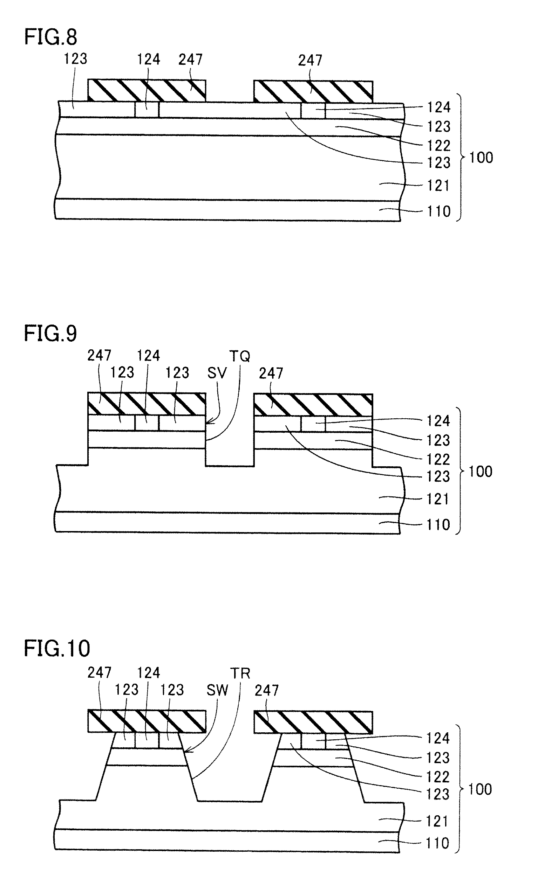

First, in step S31 (Fig. 4), a mask layer 247 is formed on n region 123 and contact region 124 as shown in Fig. 8. Mask layer 247 has an opening to partially expose n region 123 in a position corresponding to the position of trench TR (Fig. 1). For example, an insulating film such as a silicon oxide film can be used as mask layer 247. While the silicon oxide film can be formed by deposition such as plasma CVD, it is preferably formed by thermal oxidation. When forming the opening of mask layer 247, it is preferable to utilize RIE (Reactive Ion Etching) using a condition that mask layer 247 has a high etching ratio relative to epitaxial substrate 100.

Next, in step S32 (Fig. 4), as shown in Fig. 9, RIE is performed as preliminary etching prior to thermal etching that will be described later Consequently, n region 123, p type body layer 122, and a portion of n⁻ layer 121 are removed in the opening of mask layer 247. As a result, in the region where trench TR (Fig. 1) is to be formed, a recess TQ is formed which has a side wall having an inner surface SV substantially perpendicular to the main surface of single-crystal substrate 110. It is preferable to utilize inductively coupled plasma (ICP) RIE, in particular, as the RIE. Specifically, for example, ICP-RIE can be used which employs SF₆ or a mixed gas of SF₆ and O₂ as the reactive gas.

Any preliminary etching is applicable as long as it has a physical action. Other than RIE, examples of such etching include IBE (Ion Beam Etching). Moreover, this preliminary etching may be performed as overetching for forming the opening of mask layer 247.

Next, in step S33 (Fig. 4), inner surface SV of recess TQ is thermally etched. Consequently, trench TR is formed as shown in Fig. 10. The thermal etching can be performed, for example, by heating epitaxial substrate 100 in an atmosphere containing reactive gas having at least one or more types of halogen atom. The at least one or more types of halogen atom include at least one of chlorine (Cl) atom and fluorine (F) atom. This atmosphere is, for example, Cl₂, BCL₃, SF₆, or CF₄. Oxygen gas may be mixed in the reactive gas. The heat treatment temperature is preferably not less than 700°C and less than 1200°C, and is set to 900°C, for example.

As a result of the thermal etching, on the side wall of trench TR, surface SW having a portion formed of p type body layer 122 is formed. In surface SW, the special plane which will be described later is spontaneously formed.

It is noted that the reactive gas may contain a carrier gas in addition to the chlorine gas and the oxygen gas. An exemplary, usable carrier gas is nitrogen (N₂) gas, argon gas, helium gas, or the like. By supplying a sufficient amount of carrier gas in view of the volume of a reaction container where the thermal etching is performed, the accumulation of the reactive gas and the instability of reaction near the etched surface can be suppressed. Consequently, the flatness of surface SW formed by thermal etching can be further improved.

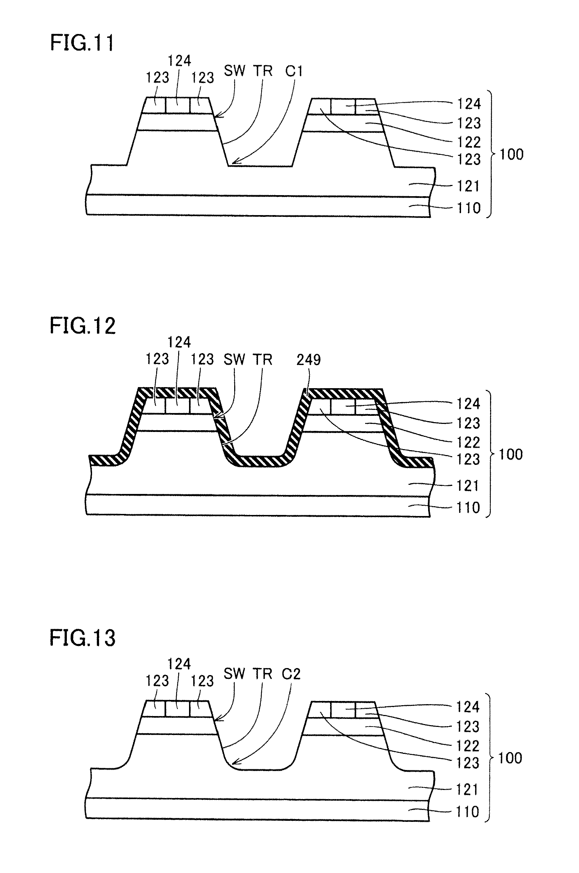

When the heat treatment temperature is set at not less than 700°C and not more than 1000°C as described above, a rate of etching SiC is approximately 70 µm/hour, for example. Moreover, in this case, mask layer 247, which is made of silicon oxide and therefore has a very large selection ratio relative to SiC, is not substantially etched during the etching of SiC Next, mask layer 247 is removed with an appropriate method such as etching (Fig. 11).

Trench TR is thus formed. As this point in time, a corner portion C1 at the bottom of trench TR tends to have a pointed shape.

Next, in step S40 (Fig. 3), a sacrificial oxidation process is performed. Specifically, first, in step S41, as shown in Fig. 12, a sacrificial oxide film 249 is formed by oxidizing the bottom of trench TR. Next, in step S42, the sacrificial oxide film is removed (Fig. 13). This alters corner portion C1 having a pointed shape (Fig. 11) into a smoother corner portion C2 (Fig. 13).

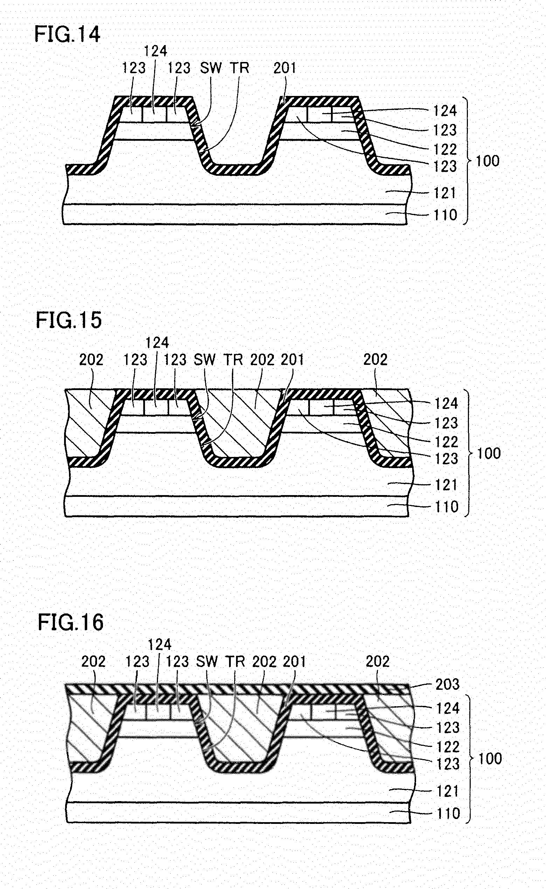

Next, in step S50 (Fig. 3), as shown in Fig. 14, gate oxide film 201 is formed to cover the side wall and the bottom of trench TR. Gate oxide film 201 is obtained, for example, by thermally oxidizing the epitaxial layer made of silicon carbide.

Next, in step S60 (Fig. 3), as shown in Fig. 15, gate electrode 202 is formed on gate oxide film 201 to fill the region in trench TR, with gate oxide film 201 interposed therebetween. A method of forming gate electrode 202 can be performed, for example, by forming a film of conductor and performing CMP (Chemical Mechanical Polishing).

A technique of forming an electric field relaxation layer by impurity implantation into the bottom of a trench in an attempt to improve breakdown voltage is conventionally known. In this embodiment, however, gate oxide film 201 and gate electrode 202 are formed without such implantation. That is, impurity implantation into the bottom of the trench is not performed in this embodiment.

Next, as shown in Fig. 16, interlayer insulating film 203 is formed on gate electrode 202 and gate oxide film 201 to cover the exposed surfaces of gate electrode 202.

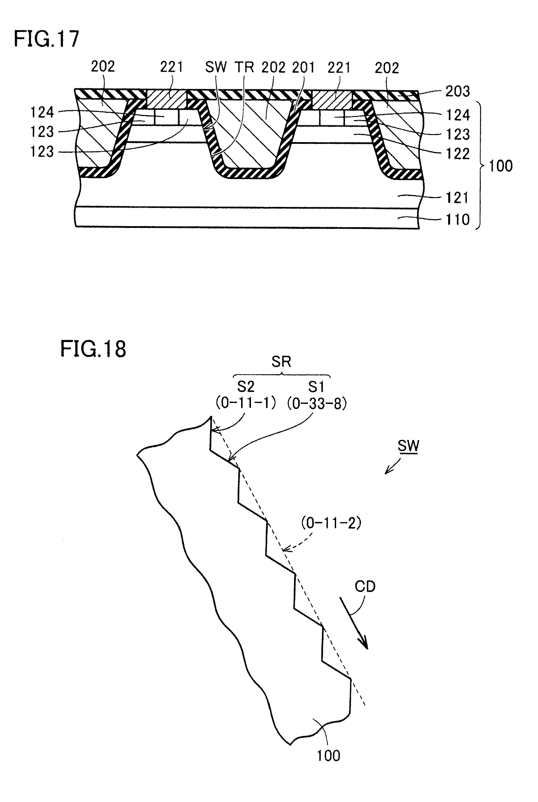

Next, in step S70 (Fig. 3), source electrode 221, drain electrode 211, source line 222 and protection electrode 212 (Fig. 1) are formed. For this purpose, as shown in Fig 17, for example, etching is first performed to form openings in interlayer insulating film 203 and gate oxide film 201. Through the openings, n region 123 and contact region 124 in the upper surfaces of the mesa structures are exposed Next, in the upper surface of each mesa structure, source electrode 221 is formed in contact with n region 123 and contact region 124. In addition, drain electrode 211, source line 222 and protection electrode 212 are formed.

MOSFET 500 (Fig. 1) is thus obtained.

According to this embodiment, surface SW forming the channel surface (Fig. 1) is formed on the side wall of trench TR after the activation heat treatment in step S22 (Fig. 4). Therefore, once formed, the channel surface is not disturbed by the activation heat treatment. Consequently, the channel resistance is suppressed, thereby reducing the ON resistance.

In contrast to this embodiment, if a method of performing the activation heat treatment after forming the trench forming the channel surface is employed, the channel resistance tends to increase for two reasons. First, the flatness of the channel surface is deteriorated due to the effect of the activation heat treatment Second, crystal defects present in epitaxial substrate 100 move to the channel surface due to the heating for the activation heat treatment, resulting in an increase in crystal defect density in the channel surface. Both the deterioration in flatness and the increase in crystal defect density in the channel surface contribute to an increase in channel resistance

In this embodiment, gate oxide film 201 and gate electrode 202 are formed without impurity ion implantation into the bottom of trench TR. Consequently, MOSFET 500 is manufactured without impurity implantation into the bottom of trench TR. Accordingly, as described above, it is not intended to perform the activation annealing after forming trench TR.

When gate oxide film 201 is formed on surface SW having satisfactory flatness as in this embodiment, the quality of gate oxide film 201 is improved, thereby lowering the possibility of breakdown of gate oxide film 201. Thus, the breakdown voltage of MOSFET 500 can be increased. Consequently, a sufficient breakdown voltage can be secured without forming an electric field relaxation layer by acceptor (impurity) ion implantation into the bottom of trench TR.

Furthermore, according to this embodiment, if the preliminary etching such as RIE (Fig. 4: step S32) is performed, an oxide on n region 123 in the opening of mask layer 247 (Fig. 8) is removed by the preliminary etching before the thermal etching (Fig. 4 step S33). Thus, the oxide can be prevented from serving as a fine mask during the thermal etching As a result, the flatness of surface SW is further improved Consequently, the channel resistance is further suppressed, thereby further reducing the ON resistance.

If the sacrificial oxidation process (Figs. 12 and 13) is performed, the corner portion at the bottom of trench TR can be further smoothed. Thus, electric field concentration in this corner portion can be suppressed to increase the breakdown voltage. Furthermore, the sacrificial oxidation process can improve the flatness of surface SW forming the channel surface.

If mask layer 247 (Fig. 8) is formed by thermal oxidation, side etching along an interface between mask layer 247 and epitaxial substrate 100 can be suppressed in a stable manner owing to a high degree of adhesion between mask layer 247 and epitaxial substrate 100. If the adhesion between mask layer 247 and epitaxial substrate 100 is low, side etching tends to occur non-uniformly, resulting in deterioration in flatness of surface SW eventually obtained.

If the opening of mask layer 247 (Fig 8) is formed by RIE (Reactive Ion Etching) using a condition that mask layer 247 has a high etching ratio relative to epitaxial substrate 100, the occurrence of roughness in an end surface of mask layer 247 (side surface of mask layer 247 in Fig. 8) can be suppressed. Consequently, the occurrence of roughness in surface SW caused by transfer of the above-described roughness in streaks to the side wall of trench TR can be suppressed.

Both p type body layer 122 and n region 123 are formed by impurity implantation. The impurities thus implanted can be activated by the above-described activation heat treatment It is noted that at least one of p type body layer 122 and n region 123 may be formed by epitaxial growth with doping of an impurity, without using ion implantation. For example, p type body layer 122 may be formed on n⁻ layer 121 by epitaxial growth of silicon carbide together with doping of an acceptor. In this case, n region 123 may be formed on p type body layer 122 by ion implantation into p type body layer 122.

The studies by the present inventors demonstrated that the use of the above-described manufacturing method could reduce the surface roughness of the side wall of trench TR having surface SW to 2 nm in RMS, and a measurement value of 1.75 nm was obtained by way of example. The measurement of surface roughness was taken over a range of 5 µm square by AFM (Atomic Force Microscopy). A method of measuring the surface roughness of surface SW can be selected depending on the shape and size of trench TR. Other than the AFM, a TEM (Transmission Electron Microscope), a SEM (Scanning Electron Microscope), or an optical microscope can be used.

While trench TR (Fig. 1) in this embodiment has a flat bottom, the shape of the trench is not limited as such, and the bottom may be a recess. For example, the trench may be substantially V-shaped. If the sacrificial oxidation process is performed in this case, the lower end of the V-shape can be smoothed.

While the first conductivity type is n type and the second conductivity type is p type in this embodiment, these conductivity types may be reversed. In order to improve the channel mobility, however, the first conductivity type is preferably n type

Furthermore, the silicon carbide semiconductor device may be a MISFET (Metal Insulator Semiconductor Field Effect Transistor) other than the MOSFET Moreover, the silicon carbide semiconductor device is not limited to the MISFET as long as it has a trench gate structure. For example, the semiconductor device may be a trench type IGBT (Insulated Gate Bipolar Transistor).

### (Surface Having Special Plane)

As described above, the side wall of trench TR (Fig. 1) has surface SW as the channel surface on p type body layer 122. Surface SW preferably has a special plane. This "special plane" is now described in detail

As shown in Fig. 18, surface SW having the special plane (saw-toothed surface in the upper right in Fig. 18) includes a plane S 1 (first plane). Plane S1 has a plane orientation of {0-33-8}, and preferably has a plane orientation of (0-33-8). Preferably, surface SW includes plane S1 microscopically. Preferably, surface SW further includes a plane S2 (second plane) microscopically. Plane S2 has a plane orientation of {0-11-1}, and preferably has a plane orientation of (0-11-1). The term "microscopically" as used herein means "minutely to such an extent that at least the size about twice as large as an interatomic spacing is considered " As a method of observing such a microscopic structure, for example, the TEM (Transmission Electron Microscope) can be used.

Preferably, surface SW includes a combined plane SR. Combined plane SR is formed of periodically repeated planes S1 and S2. Such a periodic structure can be observed, for example, by TEM or AFM (Atomic Force Microscopy). Combined plane SR has a plane orientation of {0-11-2}, and preferably has a plane orientation of (0-11-2). In this case, combined plane SR macroscopically has an off angle of 62° relative to the {000-1} plane. The term "macroscopically" as used herein means "disregarding a fine structure having a size of approximately interatomic spacing." For the measurement of such a macroscopic off angle, a method employing general X-ray diffraction can be used, for example. Preferably, in the channel surface, carriers flow in a channel direction CD, in which the above-described periodic repetition is done.

A detailed structure of combined plane SR is now described.

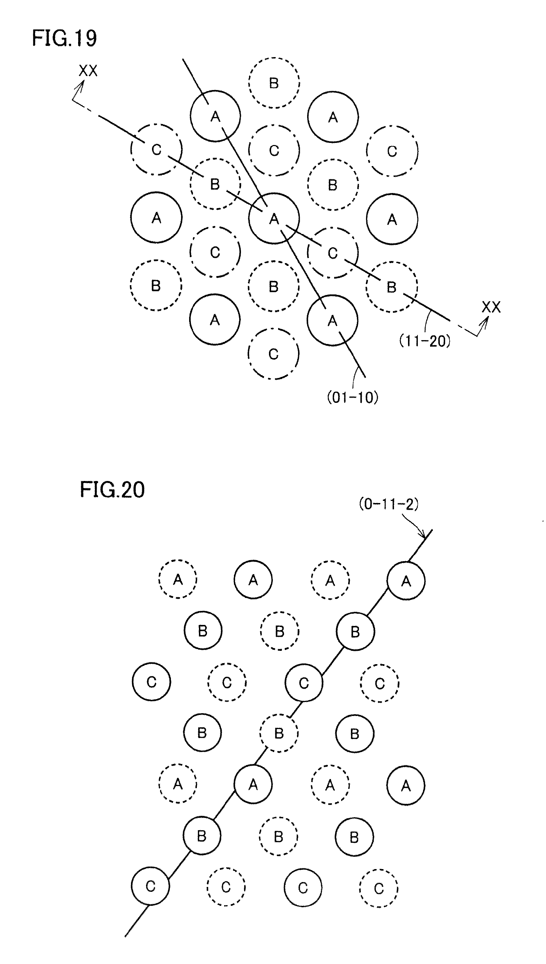

Generally, regarding Si atoms (or C atoms), when a silicon carbide single crystal of polytype 4H is viewed from the (000-1) plane, atoms in a layer A (solid line in the figure), atoms in a layer B (broken line in the figure) disposed therebelow, atoms in a layer C (chain-dotted line in the figure) disposed therebelow, and atoms in a layer B (not shown) disposed therebelow are repeatedly provided as shown in Fig. 19. In other words, with four layers ABCB being regarded as one period, a periodic stacking structure such as ABCBABCBABCB ... is provided.

As shown in Fig 20, in the (11-20) plane (cross section taken along a line XX-XX in Fig. 19), the atoms in each of four layers ABCB constituting the above-described one period are not aligned completely along the (0-11-2) plane. In Fig. 20, the (0-11-2) plane is illustrated to pass through the locations of the atoms in layers B. In this case, it can be seen that each of the atoms in layers A and C is deviated from the (0-11-2) plane. Hence, even when the macroscopic plane orientation of the surface of the silicon carbide single crystal, i.e., the plane orientation thereof with its atomic level structure being disregarded, is limited to (0-11-2), this surface can have various structures microscopically.

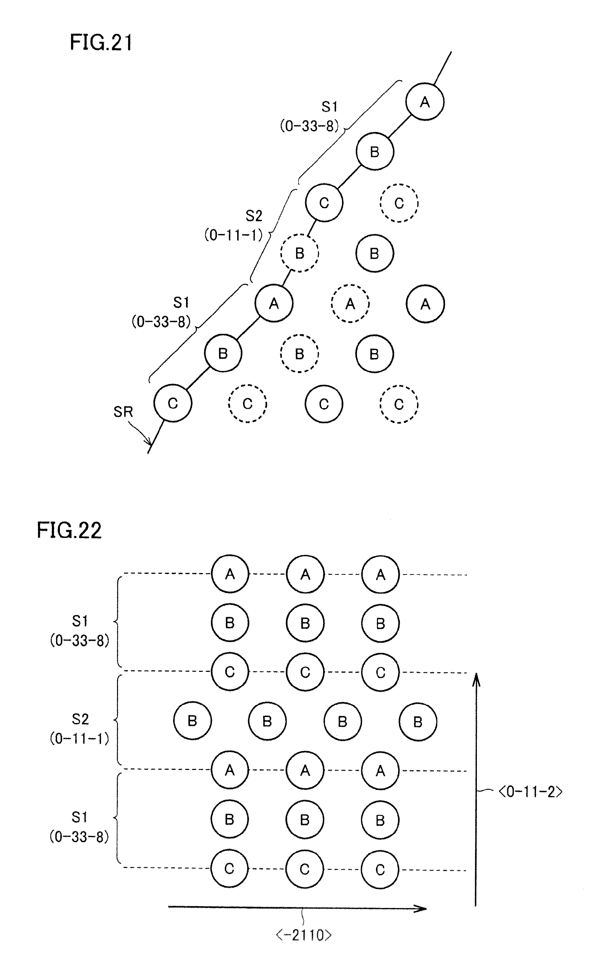

As shown in Fig. 21, combined plane SR is formed by alternately providing planes S1 having a plane orientation of (0-33-8) and planes S2 connected to planes S1 and having a plane orientation different from that of planes S1 Each of planes S1 and S2 has a length twice as large as the interatomic spacing of the Si atoms (or C atoms). It is noted that a plane with plane S1 and plane S2 being averaged corresponds to the (0-11-2) plane (Fig. 20).

As shown in Fig. 22, when combined plane SR is viewed from the (01-10) plane, the single-crystal structure has a portion periodically including a structure (the portion of plane S1) equivalent to a cubic structure. Specifically, combined plane SR is formed by alternately providing planes S1 having a plane orientation of (001) in the above-described structure equivalent to a cubic structure and planes S2 connected to planes S1 and having a plane orientation different from that of planes S1. Also in polytype other than 4H, the surface can be thus formed of the planes (planes S1 in Fig. 22) having a plane orientation of (001) in the structure equivalent to a cubic structure and the planes (planes S2 in Fig. 22) connected to the foregoing planes and having a plane orientation different from that of the foregoing planes The polytype may be 6H or 15R, for example.

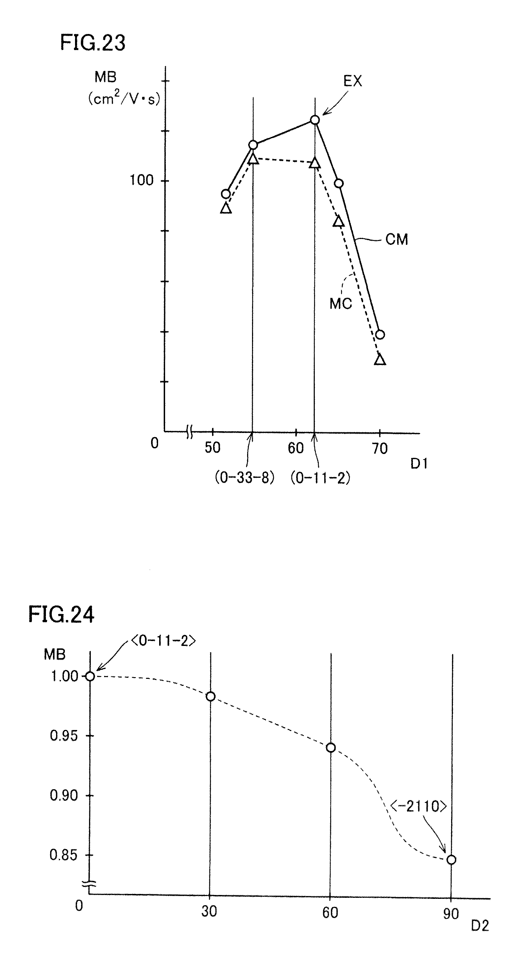

Referring now to Fig. 23, relation between the crystal plane of surface SW and mobility MB in the channel surface is described In the graph of Fig. 23, the horizontal axis represents an angle D1 formed by the (000-1) plane and the macroscopic plane orientation of surface SW having the channel surface, and the vertical axis represents mobility MB. A group of plots CM corresponds to a case where surface SW is finished to have the special plane through thermal etching, and a group of plots MC corresponds to a case where surface SW is not subjected to such thermal etching.

In group of plots MC, mobility MB is at maximum when the surface of the channel surface has a macroscopic plane orientation of (0-33-8). This is presumably due to the following reason. That is, in the case where the thermal etching is not performed, i.e., in the case where the microscopic structure of the channel surface is not particularly controlled, the macroscopic plane orientation thereof corresponds to (0-33-8), with the result that a ratio of the microscopic plane orientation of (0-33-8), i.e., the plane orientation of (0-33-8) in consideration of that in atomic level, becomes statistically high.

On the other hand, mobility MB in group of plots CM is at maximum when the macroscopic plane orientation of the surface of the channel surface is (0-11-2) (arrow EX). This is presumably due to the following reason. That is, as shown in Figs. 21 and 22, the large number of planes S1 each having a plane orientation of (0-33-8) are densely and regularly arranged with planes S2 interposed therebetween, whereby a ratio of the microscopic plane orientation of (0-33-8) becomes high in the surface of the channel surface.

It is noted that mobility MB has orientation dependency on combined plane SR. In a graph shown in Fig. 24, the horizontal axis represents an angle D2 between the channel direction and the <0-11-2> direction, and the vertical axis represents mobility MB (in any unit) in the channel surface. A broken line is supplementarily provided therein for viewability of the graph It has been found from this graph that in order to increase channel mobility MB, channel direction CD (Fig 18) preferably has an angle D2 of not less than 0° and not more than 60°, and more preferably, substantially 0°.

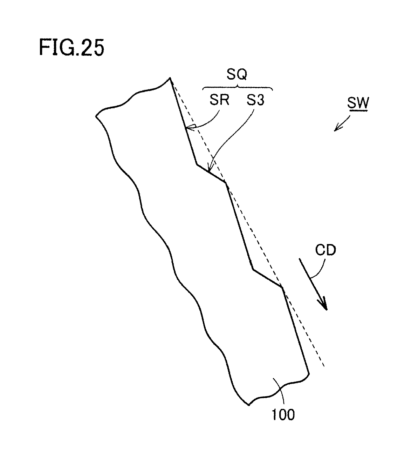

As shown in Fig. 25, surface SW may further include a plane S3 (third plane) in addition to combined plane SR. In this case, the off angle of surface SW relative to the {000-1} plane is deviated from the ideal off angle of combined plane SR, i.e., 62°. This deviation is preferably small, and preferably in a range of ±10° Examples of a surface included in such an angle range include a surface having a macroscopic plane orientation of the {0-33-8} plane. More preferably, the off angle of surface SW relative to the (000-1) plane is deviated from the ideal off angle of combined plane SR, i.e., 62°. This deviation is preferably small, and preferably in a range of ±10°. Examples of a surface included in such an angle range include a surface having a macroscopic plane orientation of the (0-33-8) plane.

More specifically, surface SW may include a combined plane SQ formed of periodically repeated planes S3 and combined planes SR. Such a periodic structure can be observed, for example, by TEM or AFM (Atomic Force Microscopy).

It should be understood that the embodiments disclosed herein are illustrative and non-restrictive in any respect. The scope of the present invention is defined by the terms of the claims, rather than the description above, and is intended to include any modifications within the scope and meaning equivalent to the terms of the claims.

### REFERENCE SIGNS LIST

100 epitaxial substrate (silicon carbide substrate); 110 single-crystal substrate; 121 n⁻ layer (first layer); 122 p type body layer (second layer); 123 n region (third layer); 124 contact region; 201 gate insulating film; 202 gate electrode; 203 interlayer insulating film; 211 drain electrode; 212 protection electrode; 221 source electrode; 222 source line; 247 mask layer; 249 sacrificial oxide film; 500 MOSFET (silicon carbide semiconductor device); CD channel direction; S1 plane (first plane); S2 plane (second plane); SQ, SR combined plane; SW surface; TR trench

## Claims

1. A method for manufacturing a silicon carbide semiconductor device, comprising the steps of:
forming a first layer of a first conductivity type made of silicon carbide;
forming a second layer of a second conductivity type different from said first conductivity type positioned on said first layer, and a third layer of said first conductivity type positioned on said second layer, said step of forming second and third layers including the steps of performing impurity ion implantation, and performing heat treatment for activating impurities implanted by said impurity ion implantation;
after said step of performing heat treatment, forming a trench having a side wall penetrating said third layer and said second layer and having a bottom reaching said first layer;
forming a gate insulating film to cover said side wall of said trench; and
forming a gate electrode on said gate insulating film.

2. The method for manufacturing a silicon carbide semiconductor device according to claim 1, wherein
said step of performing impurity ion implantation includes the steps of implanting an impurity for providing said second layer with said second conductivity type, and implanting an impurity for providing said third layer with said first conductivity type.

3. The method for manufacturing a silicon carbide semiconductor device according to claim 1 or 2, wherein
said step of forming a trench includes the steps of forming a mask layer having an opening to partially expose said third layer on said third layer, performing preliminary etching having a physical action using said mask layer, and performing thermal etching after said step of performing preliminary etching.

4. The method for manufacturing a silicon carbide semiconductor device according to any one of claims 1 to 3, further comprising the steps of:
forming a sacrificial oxide film by oxidizing said bottom of said trench; and
removing said sacrificial oxide film.

5. The method for manufacturing a silicon carbide semiconductor device according to any one of claims 1 to 4, wherein
said gate insulating film and said gate electrode are formed without impurity ion implantation into said bottom of said trench.

6. A silicon carbide semiconductor device comprising:
a silicon carbide substrate including a first layer of a first conductivity type, a second layer of a second conductivity type different from said first conductivity type on said first layer, and a third layer of said first conductivity type on said second layer, said silicon carbide substrate being provided with a trench having a side wall penetrating said third layer and said second layer and having a bottom reaching said first layer, said second layer having a surface with a surface roughness of not more than 2 nm in RMS on said side wall of said trench;
a gate insulating film covering said side wall of said trench; and
a gate electrode on said gate insulating film.

7. The silicon carbide semiconductor device according to claim 6, wherein
said second layer is made of silicon carbide having a hexagonal crystal structure of polytype 4H, and said surface of said second layer includes a first plane having a plane orientation of {0-33-8}.

8. The silicon carbide semiconductor device according to claim 7, wherein
said surface includes said first plane microscopically, and further includes a second plane having a plane orientation of {0-11-1} microscopically.

9. The silicon carbide semiconductor device according to claim 8, wherein
said first and second planes form a combined plane having a plane orientation of {0-11-2}.

10. The silicon carbide semiconductor device according to claim 9, wherein
said surface macroscopically has an off angle of 62°±10° relative to the {000-1} plane.
